# FASCICULE DE BREVET EUROPEEN

(11) **EP 0 554 195 B1**
(45) Date de publication et mention de la délivrance du brevet: **19.03.1997**
(21) Numéro de dépôt: 93420036.1
(22) Date de dépôt: 25.01.1993
(51) Int. Cl.: H01L 23/62

(54) **Composant de protection semiconducteur auto-protégé**
Selbsttätig geschütztes Halbleiterschutzelement
Auto-protected semi-conductor protection component

(30) Priorité: 29.01.1992 FR 9201245
(43) Date de publication de la demande: 04.08.1993
(73) Titulaire: SGS-THOMSON MICROELECTRONICS S.A., 94250 Gentilly (FR)
(72) Inventeur: Pezzani, Robert, F-37210 Vouvray (FR)
(74) Mandataire: de Beaumont, Michel

(56) Documents cités:
- EP-A- 0 318 404
- EP-A- 0 349 890
- EP-A- 0 364 981
- WO-A-87/01867
- US-A- 4 908 692
- PATENT ABSTRACTS OF JAPAN vol. 14, no. 580 (E-1017)25 Décembre 1990 & JP-A-22 53 651
- IEEE JOURNAL OF SOLID-STATE CIRCUITS vol. SC-8, no. 6, Décembre 1973, pages 419 - 427 W. F. DAVIS 'BIPOLAR DESIGN CONSIDERATIONS FOR THE AUTOMOTIVE ENVIRONMENT'

## Description

La présente invention concerne les composants de protection semiconducteurs réalisés sous forme monolithique. De tels composants de protection sont destinés à écrêter une tension appliquée à leurs bornes quand cette tension dépasse un seuil déterminé. Pendant la phase d'écrêtage, la tension aux bornes du composant se maintient au seuil déterminé quand le composant est du type diode à avalanche ou chute à une valeur pratiquement nulle quand le composant de protection est un composant à quatre couches du type à retournement, par exemple un triac sans gâchette.

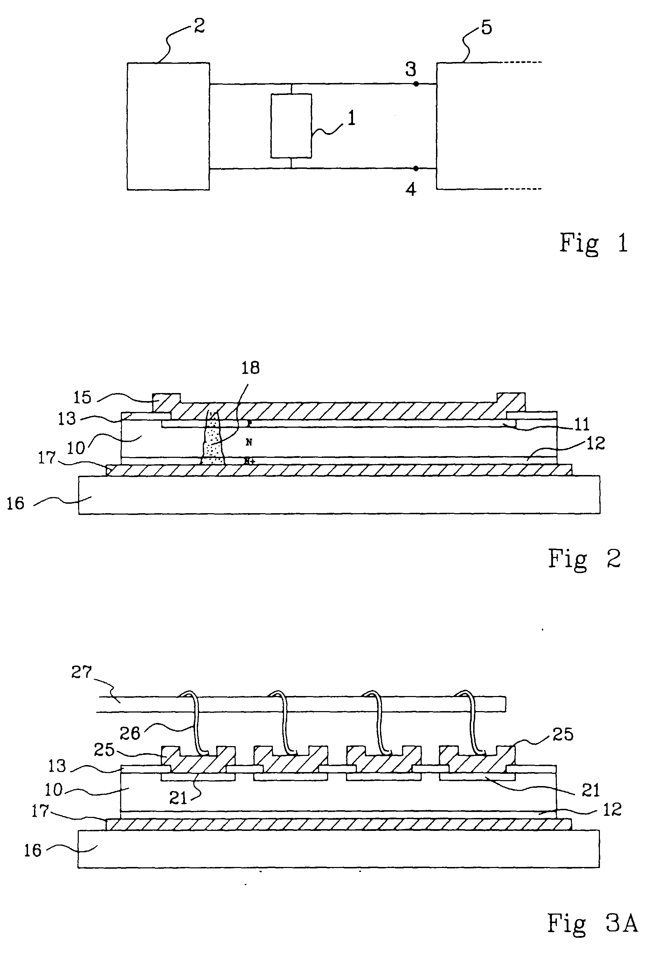

La figure 1 représente le mode de montage classique d'un composant de protection 1 disposé en parallèle sur une ligne entre une source d'alimentation 2 et des bornes d'entrée d'alimentation 3 et 4 d'un circuit 5 à protéger.

Comme on l'a indiqué précédemment, de tels composants peuvent prendre de nombreuses formes. La figure 2 représente une structure de diode à avalanche formée sur un substrat semiconducteur 10 de type N. La face avant de ce substrat comprend une région 11 de type P et la face arrière une région surdopée 12 de type N. La surface supérieure du substrat est revêtue d'une couche isolante 13, couramment de l'oxyde de silicium, ayant servi à délimiter la zone où est formée la région 11. La face supérieure est revêtue d'une métallisation 15 en contact avec la région 11.

Classiquement, la face inférieure du substrat est montée sur une embase 16 servant de radiateur, par l'intermédiaire d'une préforme de soudure 17 et la métallisation 15 est directement soudée à un "clou" de connexion.

Un tel composant de protection est destiné à absorber des surcharges ou surtensions entre la métallisation 15 et l'embase 16. Ce composant est dimensionné pour absorber une surcharge jusqu'à une certaine limite d'énergie. Cependant, il existe toujours un niveau de perturbation susceptible de détruire le composant. Habituellement, une telle destruction se traduit par l'apparition d'une région 18 de court-circuit entre les métallisations supérieure et inférieure. Ensuite, après la fin de la surtension, le composant reste en court-circuit et, dans le cas d'un montage tel que celui de la figure 1, le circuit 5 n'est plus alimenté entre ses bornes 3 et 4 tandis que la source débite en court-circuit ce qui constitue un double inconvénient. Pour remettre le circuit 5 en fonctionnement, il faut déconnecter le composant 1 et, si l'on veut que le circuit soit protégé, le remplacer par un composant neuf. Cette opération est toujours délicate et, dans certaines applications, par exemple pour des circuits embarqués sur satellite, entraîne la nécessité de prévoir des composants en double et des circuits de commutation qui nuisent à la qualité de la fonction de protection.

Pour résoudre ce problème, on est amené en pratique à utiliser des composants de protection fortement surdimensionnés pour pouvoir absorber des surtensions élevées dont la probabilité d'apparition est très faible.

Dans le document EP-A-0 318 404 une assemblage monolithique de diodes de protection indépendantes sur une puce semiconductrice est décrite.

Un objet de la présente invention est de prévoir un composant de protection semiconducteur monolithique qui reste opérationnel même après apparition d'une surcharge normalement destructrice.

Pour atteindre cet objet, la présente invention prévoit un composant de protection semiconducteur monolithique comprenant une puce semiconductrice connecté entre une première électrode associée à une première région semiconductrice apparente sur une première face de ladite puce et une deuxième région semiconductrice apparente sur une deuxième face de ladite puce, dans lequel ladite première région est séparée en plusieurs zones disjointes, chaque zone étant reliée à une électrode par l'intermédiaire d'un fusible.

Selon un mode de réalisation de la présente invention, chaque fusible est dimensionné pour s'ouvrir dans les conditions normales d'alimentation du circuit auquel est connecté le composant, quand il existe un court-circuit entre la zone correspondant à ce fusible et la deuxième région.

Selon un mode de réalisation de la présente invention, chaque fusible est constitué d'un fil d'or.

Selon un mode de réalisation de la présente invention, chaque fusible est constitué d'une métallisation.

Selon un mode de réalisation de la présente invention, le composant de protection est une diode avalanche. La première région est une région d'un premier type de conductivité formée dans une première face d'un substrat du deuxième type de conductivité et la deuxième région est une région du deuxième type de conductivité formée dans la deuxième face du substrat.

Selon un mode de réalisation de la présente invention, Le composant de protection comprend deux premières régions dont chacune constitue un composant de protection entre elle-même et la deuxième région et chacune des premières régions est divisée en zones disjointes, chaque zone du premier ensemble de zones étant relié par un fusible à une première électrode et chaque zone du deuxième ensemble de zones étant relié par un fusible à une deuxième électrode.

En d'autres termes, la présente invention prévoit un composant de protection multicellulaire tel que, quand une cellule est détruite par une surcharge excessive, un fusible associé à cette cellule se détruit et le composant continue à fonctionner grâce à ses autres cellules encore bonnes.

On pourra associer le circuit de protection selon la présente invention à un détecteur d'alarme qui indique qu'une très forte surtension est apparue sur la ligne à protéger et l'on pourra ensuite lors d'opérations de maintenance changer le composant à un instant favorable, celui-ci étant resté opérationnel et le circuit qui lui est associé ayant continué à fonctionner. Si le composant est à cinq cellules, on peut admettre qu'il pourra continuer à fonctionner même s'il a subi trois surtensions destructrices de cellules individuelles.

Ces objets, caractéristiques et avantages ainsi que d'autres de la présente invention seront exposés en détail dans la description suivante de modes de réalisation particuliers faite en relation avec les figures jointes parmi lesquelles :
les figures 1 et 2 destinées à illustrer l'état de la technique et le problème posé ont été décrites précédemment ;
les figures 3A, 3B et 3C illustrent un mode de réalisation de la présente invention dans trois états successifs, avant l'apparition d'une surcharge destructrice, pendant celle-ci, et peu après celle-ci ; et
la figure 4 représente un autre mode de réalisation de la présente invention constituant un dispositif de protection bidirectionnel.

Dans les diverses figures représentant des vues en coupe de composants semiconducteurs, comme cela est d'usage dans le domaine de la représentation des semiconducteurs, les dimensions des diverses couches ne sont pas tracées à l'échelle, leurs épaisseurs étant arbitrairement dilatées pour faciliter le tracé des figures et en améliorer la lisibilité. L'homme de l'art saura choisir les diverses épaisseurs en fonction de ses connaissances pour atteindre des caractéristiques souhaitées.

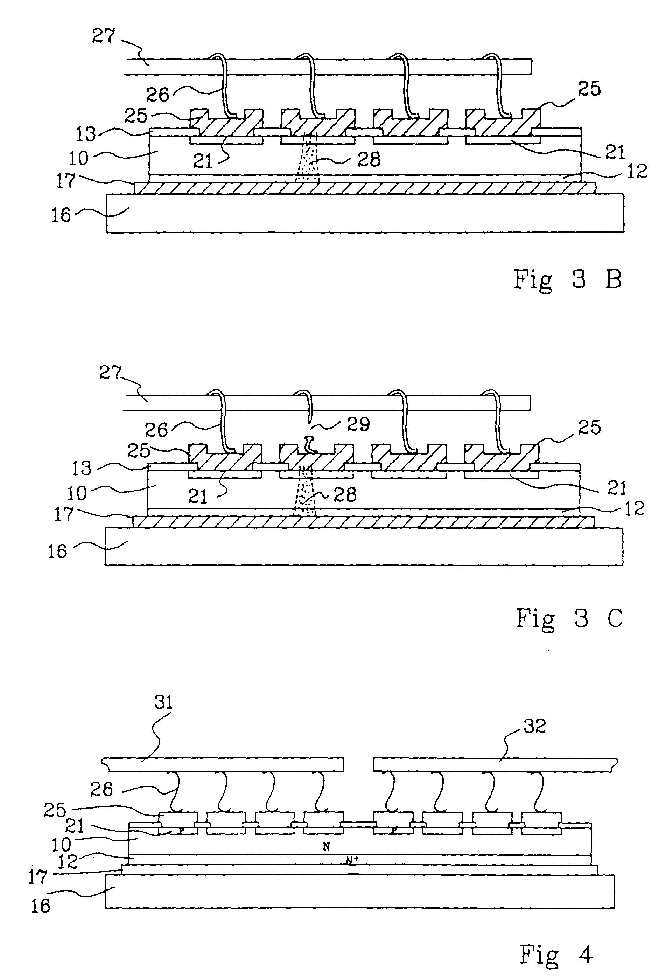

La figure 3A représente un composant de protection du même type que celui de la figure 2, modifié selon la présente invention. Dans ces figures, de mêmes éléments sont désignés par de mêmes références. Selon l'invention, la région 11 de type P est remplacée par plusieurs régions 21 de type P disjointes dont chacune est revêtue d'une métallisation 25. Chaque métallisation 25 est reliée par un fusible 26 à une électrode d'anode 27. Dans le mode de réalisation représenté, l'électrode d'anode 27 est une cosse et chacun des fusibles 26 est constitué d'un fil d'or, par exemple un fil de 50 micromètres de diamètre. En pratique, ces fils pourront éventuellement être en aluminium et sont analogues aux fils couramment utilisés pour réaliser des contacts sur des métallisations de puces de circuits intégrés. Ainsi, en fonctionnement normal, la structure de la figure 3A est une structure multicellulaire (à quatre diodes dans le mode de réalisation représenté) ayant le même comportement que la diode de la figure 2.

En cas de surcharge normale, les cellules fonctionnent en avalanche en parallèle. L'énergie se répartit de manière équilibrée entre les cellules puisque les jonctions sont identiques et présentent des caractéristiques inverses identiques en raison de la structure monolithique. Le fonctionnement normal est donc le même que celui d'un produit classique.

S'il survient une surcharge excessive, d'un niveau supérieur à la capacité d'écoulement de la puce, il se produira le phénomène de mise en court-circuit décrit en relation avec la figure 2. Toutefois, avec la structure de la présente invention, comme cela est représenté en figure 3B, la mise en court-circuit (28) se produira au niveau d'une seule cellule. L'expérience montre que ce mode de destruction se traduit par l'apparition d'un canal de fusion dans la puce entre son contact supérieur et le contact inférieur court-circuitant la jonction PN. Ce canal lié à un mécanisme de focalisation de courant se limite à des dimensions de quelques centaines de micromètres de diamètre dès que la destruction apparaît. Il y aura donc bien une seule puce détruite comme cela est représenté par la zone 28 en figure 3B. Ce phénomène de destruction est susceptible de survenir très rapidement, en des durées de l'ordre de quelques dizaines de microsecondes. Alors, si l'on revient au schéma de montage illustré en figure 1, la source de tension 2 va débiter à travers le produit de protection même après la surtension. Selon l'invention, on choisit les fils de connexion 26 pour qu'ils puissent fondre sous le débit de la source. Comme le représente la figure 3C, tout le courant de la source en court-circuit passera dans l'un des fils servant de fusible et ce fil va fondre et déconnecter la cellule endommagée. Alors, le composant retrouve sa caractéristique initiale (sa fonction de protection) mais comprend seulement trois diodes en parallèle et non plus quatre. La seule différence est que les valeurs de surcharge excessive susceptibles d'en détruire une cellule seront un peu plus faibles quand il se trouve dans la configuration de la figure 3C que quand il se trouve dans la configuration de la figure 3A.

Dans ce qui précède, on a décrit un mode de réalisation de la présente invention en relation avec une diode de protection monodirectionnelle. La présente invention s'applique également à la réalisation d'une diode de protection bidirectionnelle. La figure 4 représente un exemple de réalisation de diode de protection bidirectionnelle selon la présente invention. On y retrouve une diode multicellulaire dans laquelle une moitié des cellules est reliée à une première électrode 31 et une deuxième moitié des cellules est reliée à une deuxième électrode 32. La base 16 ne constitue alors plus une électrode mais simplement un radiateur et un conducteur de face arrière permettant la circulation de courant en cas de surtension entre les électrodes 31 et 32. Par exemple, en cas de surtension négative sur l'électrode 31, les diodes de la partie gauche de la figure entrent en avalanche, et un courant circule de l'électrode 31 vers l'embase 16 puis de l'embase 16 vers l'électrode 32 par les jonctions PN en direct. De la même façon que dans le cas précédent, en cas de surtension excessive, l'un des fils 26 lié à l'électrode 31 ou 32 sera détruit.

Les fils d'or 26 sont calibrés pour se détruire après passage d'un courant de court-circuit pendant une durée longue devant celle d'une impulsion de surtension, par exemple de l'ordre de la dizaine de millisecondes.

Dans un mode de réalisation particulier de la présente invention où l'on a réalisé une puce monolithique de deux fois cinq diodes ayant des tensions d'avalanche de 27 volts, la surface par diode étant de 1 millimètre carré, on constate qu'il peut se produire une destruction de diode pour une onde 8/20 (c'est-à-dire une surtension ayant un temps de montée de 8 microsecondes et un temps de descente de 20 microsecondes) et une intensité de 280 ampères en onde de choc. Ensuite, si les fils d'or ont un diamètre de l'ordre de 50 micromètres, la diode dégradée est mise en court-circuit par fusion du fil d'or par un courant de 3,5 ampères pendant environ 10 ms, la source de tension d'alimentation ayant une tension de l'ordre de 15 V.

La présente invention a été décrite précédemment dans le cadre d'un mode de réalisation particulier. Elle est susceptible de nombreuses variantes.
- Dans ce qui précède, on a décrit les fusibles 26 comme constitués de fils d'or reliant une plage métallisée à une électrode ou cosse. L'homme de l'art pourra employer d'autres matériaux que de l'or pour réaliser les fils calibrés. En outre, on peut aussi prévoir que chaque métallisation de diode est reliée à une électrode constituée d'une zone métallique déposée sur la puce semiconductrice par l'intermédiaire d'un fusible formé sur la puce, ce fusible étant constitué par l'une quelconque des techniques connues, par exemple sous forme d'un dépôt métallique mince du même matériau que celui constituant les contacts ou d'un autre matériau sélectionné.
- La présente invention a été décrite ci-dessus dans le cas où le composant de protection est une diode destinée à fonctionner en avalanche. L'homme de l'art notera que d'autres composants de protection se prêtent à une conception multicellulaire selon l'invention. En effet, dans d'autres composants de protection tels que des thyristors ou triacs sans gâchette, la destruction d'un composant de protection se traduit par une mise en court-circuit d'une petite zone de celui-ci.

## Revendications

1. Composant de protection semiconducteur monolithique comprenant une puce semiconductrice connecté entre une première électrode associée à une première région semiconductrice (21) apparente sur une première face de ladite puce et une deuxième électrode associée à une deuxième région semiconductrice (12) apparente sur une deuxième face de ladite puce, dans lequel ladite première région est séparée en plusieurs zones disjointes dont chacune est reliée à la première électrode (27) par l'intermédiaire d'un fusible (26).

2. Composant selon la revendication 1, caractérisé en ce que chaque fusible est dimensionné pour s'ouvrir dans les conditions normales d'alimentation du circuit auquel est connecté le composant, quand il existe un court-circuit entre la zone correspondant à ce fusible et la deuxième région.

3. Composant de protection selon la revendication 1, caractérisé en ce que chaque fusible est constitué d'un fil d'or (26).

4. Composant de protection selon la revendication 1, caractérisé en ce que chaque fusible est constitué d'une métallisation.

5. Composant de protection selon la revendication 1 constituant une diode avalanche, caractérisé en ce que la première région est une région d'un premier type de conductivité formée dans une première face d'un substrat (10) du deuxième type de conductivité et la deuxième région est une région du deuxième type de conductivité formée dans la deuxième face du substrat.

6. Composant de protection selon la revendication 1, caractérisé en ce qu'il comprend deux premières régions dont chacune constitue un composant de protection entre elle-même et la deuxième région et en ce que chacune des premières régions est divisée en zones disjointes (21), chaque zone du premier ensemble de zones étant relié par un fusible (26) à une première électrode (31) et chaque zone du deuxième ensemble de zones étant relié par un fusible à une deuxième électrode (32).

## Patentansprüche

1. Monolithische Halbleiterschutzkomponente, die folgendes aufweist: ein Halbleiterchip verbunden zwischen einer ersten Elektrode und einer zweiten Elektrode, wobei die erste Elektrode mit einer ersten Halbleiterzone (21) auf einer ersten Oberfläche des Chips assoziiert bzw. verbunden ist, während die zweite Elektrode mit einer zweiten Halbleiterzone (17) auf einer zweiten Oberfläche des Chips assoziiert oder verbunden ist, dadurch gekennzeichnet, daß die erste Zone in mehrere nicht überlappende Gebiete unterteilt ist, wobei jedes Gebiet mit der ersten Elektrode (27) über eine Sicherung (26) verbunden ist.

2. Komponente nach Anspruch 1, dadurch gekennzeichnet, daß jede Sicherung derart bemessen ist, daß sie sich bei normalen Versorgungsbedingungen der Schaltung, mit der die Komponente verbunden ist, öffnet, wenn ein Kurzschluß zwischen dem der Sicherung entsprechenden Gebiet und der zweiten Zone auftritt.

3. Komponente nach Anspruch 1, dadurch gekennzeichnet, daß jede Sicherung aus einem Golddraht (26) hergestellt ist.

4. Komponente nach Anspruch 1, dadurch gekennzeichnet, daß jede Sicherung durch eine Metallisierung gebildet wird.

5. Komponente nach Anspruch 1, die eine Lawinendiode bildet, dadurch gekennzeichnet, daß die erste Zone eine Zone eines ersten Leitfähigkeitstyps ist, und zwar gebildet auf einer ersten Oberfläche eines Substrats (10) des zweiten Leitfähigkeitstyps, und daß die zweite Zone eine Zone des zweiten Leitfähigkeitstyps ist, und zwar gebildet auf der zweiten Oberfläche des Substrats.

6. Komponente nach Anspruch 1, dadurch gekennzeichnet, daß sie zwei erste Zonen aufweist, deren jede eine Schutzkomponente bildet, und zwar zwischen der ersten Zone und der zweiten Zone, wobei jede erste Zone in nicht überlappende Gebiete (21) unterteilt ist, wobei jedes Gebiet der ersten Gruppe von Gebieten durch eine Sicherung (26) mit einer ersten Elektrode (31) verbunden ist, und wobei jedes Gebiet der zweiten Gruppe von Gebieten durch eine Sicherung mit einer zweiten Elektrode (32) verbunden ist.

## Claims

1. A monolithic semiconductor protection component comprising a semiconductor chip connected between a first electrode associated with a first semiconductor region (21) apparent on a first surface of said chip and a second electrode associated with a second semiconductor region (12) apparent on a second surface of said chip, characterized in that said first region is divided into several non-overlapping areas, and each area is connected to said first electrode (27) through a fuse (26).

2. A component according to claim 1, characterized in that each fuse is sized so as to open under normal supply conditions of the circuit to which is connected said component, when a shorting occurs between the area corresponding to said fuse and said second region.

3. A component according to claim 1, characterized in that each fuse is made of a gold filament (26).

4. A component according to claim 1, characterized in that each fuse is made of a metallization.

5. A component according to claim 1 constituting an avalanche diode, characterized in that the first region is a region of a first conductivity type formed in a first surface of a substrate (10) of the second conductivity type, and the second region is a region of the second conductivity type formed in the second surface of said substrate.

6. A component according to claim 1, characterized in that it includes two first regions, each of which forms a protection component between said first region and second region, and each first region is divided into non-overlapping areas (21), each area of the first group of areas being connected by a fuse (26) to a first electrode (31), and each area of the second group of areas is connected by a fuse to a second electrode (32).
